# FASCICULE DE BREVET EUROPEEN

(11) **EP 1 815 039 B1**
(45) Date de publication et mention de la délivrance du brevet: **23.03.2011**
(21) Numéro de dépôt: 05815720.7
(22) Date de dépôt: 21.10.2005
(51) Int. Cl.: C23C 14/20, C22C 14/00

(54) **UTILISATION D'UN ALLIAGE A BASE DE TITANE-CUIVRE-NICKEL**
VERWENDUNG EINER LEGIERUNG AUF TITAN-KUPFER-NICKEL-BASIS
USE OF A TITANIUM-COPPER-NICKEL-BASED ALLOY

(30) Priorité: 05.11.2004 FR 0452535
(43) Date de publication de la demande: 08.08.2007
(73) Titulaire: H.E.F., 42160 Andrézieux-Bouthéon (FR)
(72) Inventeur: MARTIN, Michel, F-38780 SEPTEME (FR); FAVERJON, Frédéric, F-42330 CHAMBOEUF (FR)
(74) Mandataire: Thivillier, Patrick
(86) Numéro de dépôt international: PCT/FR2005/050882
(87) Numéro de publication internationale: WO 2006/048568

(56) Documents cités:
- EP-A- 0 682 368
- FR-A1- 2 768 096
- US-A- 4 477 488
- US-A- 5 133 757
- US-A1- 2002 027 727
- US-A1- 2002 189 719
- US-A1- 2003 223 136
- US-B1- 6 562 471
- PATENT ABSTRACTS OF JAPAN vol. 007, no. 160 (P-210), 14 juillet 1983 (1983-07-14) -& JP 58 068229 A (TOKYO DENKI KAGAKU KOGYO KK), 23 avril 1983 (1983-04-23)
- PATENT ABSTRACTS OF JAPAN vol. 013, no. 224 (C-599), 24 mai 1989 (1989-05-24) -& JP 01 037482 A (NIPPON STEEL CORP), 8 février 1989 (1989-02-08)

## Description

L'invention concerne un substrat en polymère dont l'une des faces au moins est agencée pour constituer une zone chauffante.

Différentes solutions techniques ont été proposées pour réaliser des résistances chauffantes sur un substrat. Par exemple, on peut coller sur le substrat des éléments chauffants sous forme d'une résistance constituée par un fil de cuivre par exemple. Cette solution n'est toutefois pas satisfaisante car elle entraîne un process de fabrication long et onéreux conduisant à des contraintes d'intégration et pouvant conduire à un décollement au moins partiel de l'élément chauffant lors des cycles de chauffe liés aux variations d'humidité de l'environnement

Une autre solution susceptible de remplacer le collage est de déposer des matériaux résistifs par voie électrolytique. Toutefois, outre le fait que le niveau d'adhérence obtenu n'est pas satisfaisant, il apparaît que l'électrolyse est limitée au dépôt d'un petit nombre de matériaux dont la résistivité est trop faible pour constituer un élément chauffant, sans réalisation de circuit résistif par des procédés complexes de dépôts sélectifs, de gravure ou de marquage.

Compte tenu de ce qui précède, pour résoudre le problème posé d'obtenir une adhérence élevée et durable, en même temps qu'un choix important de matériaux présentant une résistivité satisfaisante, il est apparu que les techniques de dépôt sous vide, notamment par pulvérisation cathodique, peuvent constituer une solution satisfaisante.

Ainsi le brevet US 6,365,483 décrit une méthode permettant de créer un système chauffant à partir de dépôt sous vide d'un matériau résistif connu de l'homme du métier. La solution technique décrite dans ce document n'est pas satisfaisante car elle impose un process long et onéreux impliquant au moins une étape de réalisation d'un circuit résistif par des technologies de photolithographie afin d'obtenir la résistance désirée du film.

US 2003/223136 A1 décrit un rétroviseur chauffant comportant un substrat plastique recouverte d'une couche mince résistive métallique en titane, en nickel ou en alliage de titane ou de nickel réalisée par pulvérisation cathodique. La face opposée à celle revêtue de la couche résistive peut être revêtue d'une couche réflectrice et la couche résistive peut être assujettie à une source d'énergie.

US 2002/027727 décrit un rétroviseur en particulier pour véhicules comportant un substrat plastique recouverte d'une couche réflectrice.

Un autre problème technique à résoudre apparaît au niveau du matériau à utiliser, en fonction des applications visées, lorsque le système chauffant doit fonctionner dans une ambiance corrosive. Ce peut être le cas, par exemple, pour assurer le dégivrage des rétroviseurs des véhicules automobiles, où le substrat recevant la partie réfléchissante, peut être chauffé. La couche résistante, autrement dit la couche chauffante, doit résister à ce type d'ambiance. Par ailleurs, la couche résistante doit pouvoir avantageusement être alimentée sous une tension de 12 V ou 48 V par exemple, mais ne doit pas être trop mince, pour être maîtrisée facilement par le procédé conventionnel, ni trop épaisse afin de ne pas augmenter son coût et diminuer sa longévité pour des raisons parfaitement connues de l'homme du métier (fissurations, contraintes résiduelles, etc...). Cette double contrainte résultant d'une l'épaisseur déterminée, d'une part, et de la nécessité d'une tension d'alimentation, d'autre part, définit impérativement une gamme de résistivité acceptable pour le choix du matériau.

Il est apparu que les matériaux actuellement disponibles et connus pour présenter des caractéristiques de résistivité, ne permettent pas d'atteindre de tels objectifs.

D'une manière surprenante et inattendue, il est apparu que des alliages à base de titane-cuivre-nickel constituent une solution satisfaisante pour la résolution du problème posé, étant donné que de tels alliages présentent une résistivité comprise entre 200 et 300 µohm/cm ainsi qu'une excellente résistance à la corrosion (supérieure à 400 heures au brouillard salin), selon la norme NFX41002.

Si de tels alliages titane-cuivre-nickel sont parfaitement connus par l'homme du métier, en tant qu'alliage de brasure (Brevet US 3,652,237) pouvant être utilisé pour ses caractéristiques biocompatibles (Brevet US 4,774,953) ou encore pour ses qualités de promoteur d'adhésion dans des composites à matrice métallique (Brevets US 5,645,747, US 5,530,228), ils ne le sont pas pour présenter des caractéristiques de résistivité, aucune publication n'ayant mis en évidence de telles caractéristiques.

Il a également été observé que, contrairement à la plupart des matériaux déposés en couches minces, cette gamme d'alliages titane-cuivre-nickel, a la particularité de conserver constante la résistivité, même après plusieurs cycles chauffage-refroidissement.

Compte tenu de cette découverte, l'invention concerne une utilisation d'un alliage à base de titane-cuivre-nickel pour la formation d'au moins une couche mince résistive sur un substrat.

Pour résoudre le problème posé de réaliser des couches minces résistantes d'épaisseur déterminée, l'alliage est appliqué sur le substrat par pulvérisation cathodique. L'épaisseur de la couche mince est comprise entre 100 et 160 nanomètres environ.

Avantageusement, l'alliage est constitué en fraction massique de 69 % en poids de titane, 15,5 % en poids de cuivre et 15,5 % en poids de nickel. Plus généralement, l'alliage est constitué de 50 à 80 % en poids de titane, de 10 à 25 % en poids de cuivre et de 10 à 25 % en poids de nickel.

Selon un exemple d'application, le substrat constitue une surface plane dont la face opposée à celle revêtue de la couche résistive à l'alliage de titane-cuivre-nickel, est revêtue d'une couche réflectrice, ladite couche résistive est assujettie à une source d'énergie pour la soumettre à une tension d'environ 12V ou 48V.

Le substrat peut avantageusement constituer un support de la partie « miroir » d'un rétroviseur de véhicule automobile en utilisant notamment ladite couche résistive pour assurer la fonction de dégivrage de cette dernière.

L'invention sera mieux comprise à l'aide des exemples ci-après donnés à titres indicatifs nullement limitatifs.

### Exemples conformes à l'invention :

On cherche à dissiper une puissance de 12 W sur un substrat rectangulaire en polycarbonate au moyen d'une tension d'alimentation de 12 V, ce qui conduit à définir une couche résistive ayant une résistance totale de 12 Ohms. En appliquant sur cette surface, par pulvérisation cathodique magnétron (PVD), une couche d'alliage titane-cuivre-nickel de composition Ti69 Cu15,5 Ni 15,5 (fraction massique), dont la résistivité est mesurée à 250 µohm/cm, on obtient alors la résistance de 12 ohms pour une épaisseur de couche de 130 nanomètres. La couche résistive ainsi obtenue permet de dissiper, sous une tension de 12 V, une puissance de 12 W pendant une durée de 1000 h sans aucun décollement ni dégradation de la couche. A l'issue de ce test, la résistivité a varié de seulement 3 % par rapport à sa valeur initiale. Par ailleurs, soumise à un essai de brouillard salin selon la norme NFX41002, la résistance n'a subi aucune altération (on peut construire ainsi d'autres exemples conformes à l'invention).

### Exemples non conformes à l'invention :

- Alliage titane-cuivre-nickel, de composition massique Ti2Cu66Ni32. Sa résistivité est de 42 µohm.cm, ce qui conduirait, dans les mêmes conditions que l'exemple 1, à l'obtention d'une résistance de 12 ohm pour une épaisseur de couche de 22 nanomètres, ce qui est totalement irréaliste, sur des pièces non planes.
- Des essais ont été réalisés avec des couches de titane pur dont la résistivité a été mesurée à 140 µohm/cm, l'épaisseur nécessaire de la couche est alors de 90 à 100 nanomètres. De même, l'alliage nickel/vanadium, à 4 % vanadium, est connu pour cet usage, sa résistivité de 80 µohm.cm conduit à des couches dont l'épaisseur est comprise entre 20 et 50 nanomètres. Ces épaisseurs sont proches de la limite d'épaisseurs atteignables avec une fiabilité suffisante par des procédés industriels connus. De plus, il a été observé, sur substrat polymère, que pour des épaisseurs inférieures à 100 nanomètres, il n'est pas possible de dissiper une puissance de 12 W sans entraîner la destruction prématurée de la couche résistive.

La présente invention n'est pas limitée au mode de réalisation qui a été explicitement décrit, mais elle en inclut les diverses variantes et généralisations contenues dans le domaine des revendications ci-après.

Les avantages ressortent bien de la description.

## Revendications

1. Utilisation d'un alliage à base de titane-cuivre-nickel pour la formation d'au moins une couche mince résistive sur un substrat, en polymère, l'alliage est constitué de 50 à 80 % en poids de titane, de 10 à 25 % en poids de cuivre et de 10 à 25 % en poids de nickel, l'épaisseur de la couche mince est comprise entre 100 et 160 nanomètres.

2. Utilisation selon la revendication 1, **caractérisée en ce que** l'alliage est appliqué sur le substrat par pulvérisation cathodique.

3. Utilisation selon la revendication 1, **caractérisée en ce que** l'alliage est avantageusement constitué de 69 % en poids de titane de 15,5 % en poids de cuivre et de 15,5 % en poids de nickel.

4. Utilisation selon la revendication 1, **caractérisée en ce que** le substrat constitue une surface dont la face opposée à celle revêtue de la couche résistive à l'alliage de titane-cuivre-nickel, est revêtue d'une couche réflectrice, ladite couche résistive est assujettie à une source d'énergie pour la soumettre à une tension d'environ 12V.

## Claims

1. Use of a titanium-copper-nickel based alloy for the formation of at least one thin resistive film on a polymer substrate, the alloy comprising between 50 and 80 % by weight of titanium, between 10 and 25 % by weight of copper and between 10 and 25 % by weight of nickel, and the thickness of the thin film being between 100 and 160 nanometres.

2. Use as claimed in claim 1, **characterized in that** the alloy is applied to the substrate by cathode sputtering.

3. Use as claimed in claim 1, **characterized in that** the alloy comprises to advantage 69 % by weight of titanium, 15.5 % by weight of copper and 15.5 % by weight of nickel.

4. Use as claimed in claim 1, **characterized in that** the substrate comprises a surface whereof the face opposite the one that is coated with the resistive film in titanium-copper-nickel alloy, is coated with a reflective film, said resistive film being subjected to an energy source in order to expose it to a voltage of about 12V.

## Patentansprüche

1. Verwendung einer Legierung auf Titan-Kupfer-Nickel-Basis für die Bildung mindestens einer resistiven dünnen Schicht auf einem Trägermaterial aus Polymer, wobei die Legierung aus 50 - 80 % Gewichtsanteilen Titan, 10 - 25 % Gewichtsanteilen Kupfer und 10 - 25 % Gewichtsanteilen Nickel besteht und die Dicke der dünnen Schicht zwischen 100 und 160 Nanometer beträgt.

2. Verwendung nach Anspruch 1, **dadurch gekennzeichnet, dass** die Legierung durch kathodische Zerstäubung auf das Trägermaterial aufgebracht wird.

3. Verwendung nach Anspruch 1, **dadurch gekennzeichnet, dass** die Legierung vorteilhafterweise aus 69 % Gewichtsanteilen Titan, 15,5 % Gewichtsanteilen Kupfer und 15,5 % Gewichtsanteilen Nickel besteht.

4. Verwendung nach Anspruch 1, **dadurch gekennzeichnet, dass** das Trägermaterial eine Oberfläche bildet, deren der resistiven Schicht aus der Titan-Kupfer-Nickel-Legierung entgegengesetzte Seite mit einer reflektierenden Schicht überzogen ist, wobei die besagte resistive Schicht von einer Energiequelle abhängt, um einer Spannung von ca. 12 V unterzogen zu werden.
